# EUROPEAN PATENT APPLICATION

(11) **EP 4 603 623 A1**
(43) Date of publication of application: **20.08.2025**
(21) Application number: 23887750.0
(22) Date of filing: 23.10.2023
(51) Int. Cl.: C30B 15/00, C30B 15/20, C30B 29/06

(54) **MONOCRYSTALLINE SILICON PULLING DEVICE AND METHOD**

(30) Priority: 08.11.2022 CN 202211392983
(71) Applicant: Jingao Solar Co., Ltd., Xingtai, Hebei 055550 (CN)
(72) Inventor: HUANG, Xuguang, Xingtai, Hebei 055550 (CN); LI, Chaoyang, Xingtai, Hebei 055550 (CN); LIU, Shilong, Xingtai, Hebei 055550 (CN)
(74) Representative: Sun, Yiming
(86) International application number: PCT/CN2023/125971
(87) International publication number: WO 2024/099058

(57) **Abstract**

A monocrystalline silicon drawing device and method are disclosed. The drawing device comprises a melting furnace, which melts a solid silicon material into molten silicon; a plurality of pulling furnaces, which are uniformly distributed around the melting furnace, and receive the molten silicon from the interior of the melting furnace, then grow the molten silicon into monocrystalline silicon by pulling; a material conveying portion, which is provided between the melting furnace and one or more of the plurality of pulling furnaces and conveys the molten silicon within the melting furnace into one or more of the plurality of pulling furnaces. Solid silicon material melting and monocrystalline drawing are performed in two different furnaces, respectively, and a production mode, in which one melting furnace is used together with a plurality of pulling furnaces, is adopted so as to increase the production efficiency and reduce the energy consumption.

## Description

### Cross Reference to Related Applications

The application claims priority to CN Patent Application No. 202211392983.9, which was filed on November 8, 2022, and the contents of which are hereby incorporated by reference in its entirety.

### Technical Field

The disclosure relates to the technical field of Czochralski monocrystalline silicon, and in particular to a monocrystalline drawing device and method.

### Background

At present, production of monocrystalline silicon is that melting and drawing of a silicon material are completed in one monocrystalline furnace, that is, the silicon material is first loaded into a crucible within the monocrystalline furnace, and is drawn above the crucible after being completely melted, into the monocrystalline silicon drawing process. The silicon material is required to be heated to a temperature above its melting point so as to be melted, the monocrystalline silicon is required to be cooled to a temperature below its melting point so as to be drawn, and in order to perform the two processes of silicon material melting and monocrystalline silicon drawing simultaneously within the same monocrystalline furnace, it is required to ensure both the high temperature within the crucible and the low temperature above the crucible, which results in a comparatively low production efficiency, a large heat loss, and a high electricity consumption. In addition, the silicon material melting is required to be completed before the monocrystalline drawing within the same monocrystalline furnace, which results in a low production efficiency.

### Summary

The first purpose of the disclosure lies in providing a monocrystalline silicon drawing device, which achieves the separation of the silicon material melting and the monocrystalline drawing, and achieves the effect of increasing the production efficiency and saving the electricity.

The second purpose of the disclosure lies in providing a monocrystalline silicon drawing method, which performs drawings using the aforesaid monocrystalline silicon drawing device.

In order to achieve the aforesaid purposes, the disclosure provides the following technical solutions: a monocrystalline silicon drawing device, comprising: a melting furnace, which melts a solid silicon material into molten silicon; a plurality of pulling furnaces, which are uniformly distributed around the melting furnace, and receive the molten silicon from the interior of the melting furnace, then grow the molten silicon into monocrystalline silicon by pulling; a material conveying portion, which is provided between the melting furnace and one or more of the plurality of pulling furnaces and conveys the molten silicon within the melting furnace into one or more of the plurality of pulling furnaces.

Optionally, the material conveying portion is provided between the melting furnace and each of the pulling furnaces, and the melting furnace is made to communicate with one or more of the plurality of pulling furnaces by selectively making one or more of the plurality of material conveying portions be in a communicating or closed state.

Optionally, the melting furnace is configured to be rotatable, and one or more of the material conveying portions are fixed on the melting furnace, and the melting furnace drives the material conveying portion to rotate until it communicates with one or more of the plurality of pulling furnaces when it rotates.

Optionally, the melting furnace is provided therein with a first crucible for accommodating the solid silicon material and the molten silicon and a first heater for heating the first crucible; the pulling furnace is provided therein with a second crucible for accommodating the molten silicon and a second heater for heating the second crucible, and the first crucible and the second crucible are both provided thereabove with a heat-insulation cover.

Optionally, the material conveying portion includes a connecting pipe and a switch valve provided on the connecting pipe, one end of the connecting pipe extends into the first crucible within the melting furnace, the other end of the connecting pipe extends into the second crucible within the pulling furnace, and under an effect that the pressure within the melting furnace is greater than the pressure within the pulling furnace, the molten silicon within the first crucible flows into the second crucible within the pulling furnace through the connecting pipe.

Optionally, the upper side wall of the melting furnace is provided with an argon gas inlet and the lower side wall thereof is provided with an argon gas outlet, and the pressure of the melting furnace is controlled by adjusting the argon gas flow rate of the argon gas inlet and the argon gas discharge rate of the argon gas outlet, so that the pressure within the melting furnace is greater than the pressure within the pulling furnace.

Optionally, the connecting pipe includes a vertical portion and an inclined portion that communicate with each other, the vertical portion is located within the melting furnace, and the lower end of the vertical portion extends into the first crucible; the inclined portion is connected to the upper end of the vertical portion and extends downwards from the interior of the melting furnace to the second crucible of the pulling furnace in an inclined manner.

Optionally, the inclined portion includes a first inclined portion and a second inclined portion, the first inclined portion extends into the melting furnace, the second inclined portion extends into the pulling furnace, the first inclined portion and the second inclined portion are connected by a flange, and the switch valve is installed at the flange, and the first inclined portion and the second inclined portion communicate with or are closed to each other by the switch valve.

Optionally, the bottom of the first crucible is provided with liftable crucible support legs, wherein when the molten silicon is conveyed to the pulling furnace, the crucible support legs drive the first crucible to rise so that the lower end of the vertical portion contacts the liquid level of the molten silicon within the first crucible; after the completion of the conveyance of the molten silicon to the pulling furnace, the crucible support legs drive the first crucible to descend so that the lower end of the vertical portion is separated from the liquid level of the molten silicon within the first crucible.

In order to achieve the second purpose, the disclosure further provides a monocrystalline silicon drawing method, which performs drawing using the monocrystalline silicon drawing device, the drawing method comprising the steps of: S101: melting a solid silicon material into molten silicon within a melting furnace; S102: conveying, by a material conveying portion, the molten silicon within the melting furnace into one or more of the plurality of pulling furnaces; S103: pulling the molten silicon into monocrystalline silicon within the pulling furnace.

The embodiments of the disclosure have at least the following advantages:
Only the silicon material melting process is performed in the melting furnace, and only the monocrystalline drawing process is performed in the pulling furnace. The two processes of the silicon material melting and the monocrystalline drawing are performed separately, a plurality of pulling furnaces are uniformly distributed around the melting furnace, the melting furnace communicates with one or more of the plurality of pulling furnaces by the material conveying portion, and then the molten silicon within the melting furnace can be conveyed into one or more of the plurality of pulling furnaces, which achieves a production mode, in which one melting furnace is used together with a plurality of pulling furnaces. On the one hand, the temperature within the melting furnace and the temperature within the pulling furnace do not affect each other, which avoids the energy offset and reduces the energy consumption. On the other hand, the pulling efficiency of the pulling furnace may not be affected by the melting progress within the melting furnace, which improves the production efficiency.

### Brief Description of the Drawings

In order to more clearly describe the technical solutions in the embodiments of the disclosure or the traditional techniques, figures to be used in the embodiments will be briefly introduced below. It is apparent that the figures in the descriptions below are only used for some embodiments of the disclosure, and those skilled in the art may also obtain other figures based on these figures without making inventive efforts.
FIG. 1 is a schematic diagram of a structure of a monocrystalline silicon drawing device in Embodiment I of the disclosure;
FIG. 2 is a schematic diagram of pulling furnaces uniformly distributed around a melting furnace in Embodiment I of the disclosure;
FIG. 3 is a schematic diagram of a structure of a monocrystalline silicon drawing device in Embodiment II of the disclosure;
FIG. 4 is a schematic diagram of pulling furnaces uniformly distributed around a melting furnace in Embodiment II of the disclosure;
FIG. 5 is a schematic flow chart of a monocrystalline silicon drawing method in Embodiment III of the discourse.

### Descriptions of the figures:

1. melting furnace; 11. base rotating device; 12. first heater; 121. first bottom heater; 122. first side heater; 13. first crucible; 14. heat-insulation cover; 15. feeding port; 16. argon gas inlet; 17. argon gas outlet; 18. crucible support leg; 2. pulling furnace; 21. second heater; 22. second crucible; 3. connecting pipe; 31. vertical portion; 32. inclined portion; 321. first inclined portion; 322. second inclined portion; 4. molten silicon; 5. monocrystalline silicon; 6. connecting pipe heat-insulation cover; 7. switch valve.

### Detailed Description

It should be noted that the detailed descriptions below are all illustrative, and are intended to provide further explanations of the disclosure. Unless indicated otherwise, all the technical and scientific terms used herein have meanings the same as those commonly understood by those skilled in the technical field to which the disclosure belongs.

It should be noted that the terms used herein are intended to describe specific implementation schemes only, and are not intended to limit exemplary implementation schemes according to the disclosure. As used herein, unless explicitly mentioned in the context otherwise, a singular form is also intended to include a plural form. In addition, it should be understood that when the terms "comprise" and/or "include" are used in the Description, it is indicated that features, steps, operations, devices, components and/or combinations thereof exist.

In order to make the purposes, technical solutions and advantages of the embodiments of the disclosure be clearer, the respective embodiments of the disclosure will be illustrated in detail below by taking the figures into consideration. However, those skilled in the art may understand that in order to make readers better understand the disclosure, many technical details are provided in the respective embodiments of the disclosure, but even without these technical details and various changes and modifications based on the respective embodiments below, the technical solutions claimed in the disclosure may also be implemented. The division of the respective embodiments below is performed for the convenience of descriptions, and shall not form any limitation on the specific implementation schemes of the disclosure, and the respective embodiments may be combined with each other and may refer to each other without contradictions.

The embodiment of the disclosure provides a monocrystalline silicon drawing device, and the monocrystalline silicon drawing device provided by the embodiment is described in detail below.

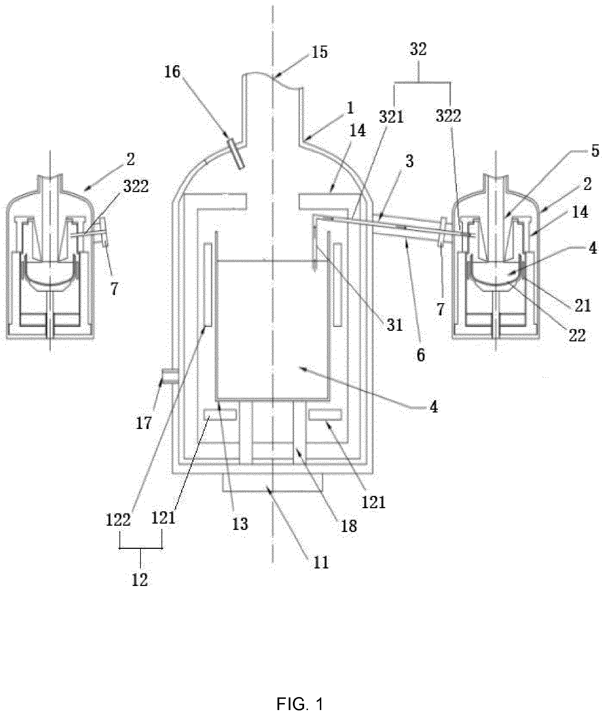

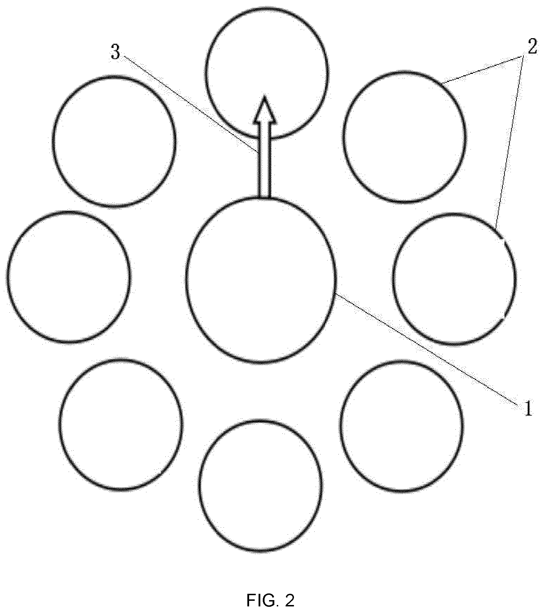

As shown in FIG. 1 and FIG. 2, a melting furnace 1, a pulling furnace 2 and a material conveying portion are included, and the melting furnace 1 is mainly used for melting a solid silicon material into molten silicon 4. There are a plurality of pulling furnaces 2, which are uniformly distributed around the melting furnace 1, and the pulling furnaces 2 mainly receive the molten silicon 4 from the interior of the melting furnace 1 and grow the molten silicon 4, which is used as a raw material, into monocrystalline silicon 5 by pulling. The material conveying portion is provided between the melting furnace 1 and one or more of the plurality of pulling furnaces 2 and is used for conveying the molten silicon 4 within the melting furnace 1 into one or more of the plurality of pulling furnaces 2.

Only the silicon material melting process is performed in the melting furnace 1, and only the monocrystalline silicon drawing process is performed in the pulling furnace 2. The two processes do not affect each other. The melting furnace 1 can communicate with one or more of the plurality of pulling furnaces 2 by the material conveying portion, so a production mode, in which one melting furnace 1 is used together with a plurality of pulling furnaces 2, is achieved, which not only increases the production efficiency but also reduces the energy consumption. Meanwhile, the pulling furnace 2 saves the time for melting the solid silicon material, and the yield of a single pulling furnace 2 is greatly increased.

In this embodiment, it should be noted that please continue to refer to FIG. 1, where it is shown that the melting furnace 1 is configured to be able to independently rotate around its own axis in a range of 360 degrees, one or more material conveying portions are fixed on the melting furnace 1, and the melting furnace 1 may drive the material conveying portion to rotate until it communicates with one or more of the plurality of pulling furnaces 2 when it rotates. In this embodiment, only the case where one material conveying portion is fixed on the melting furnace 1 is used as an example for the descriptions, so the melting furnace 1 may selectively communicate with any of the plurality of pulling furnaces 2 when it rotates.

A base rotating device 11 is installed at the bottom of the melting furnace 1, the base rotating device 11 is used for driving the melting furnace 1 to rotate around its own axis, and the base rotating device 11 may rotate the melting furnace 1 by means of gear transmission or the like. Certainly, other manners that can achieve driving the melting furnace 1 to rotate may also be adopted, which manners are not listed in the disclosure, and as long as the manners are within the aforesaid spirit and principle of the embodiment of the disclosure, they fall within the scope of protection of the disclosure.

In an optional implementation scheme, the melting furnace 1 is provided therein with a first heater 12 and a first crucible 13, and the first crucible 13 is used for holding the solid silicon material, which is melted into the molten silicon 4 under the heating effect of the first heater 12, wherein the capacity of the first crucible 13 in this embodiment is designed to be able to accommodate more than one ton of solid silicon material. The first heater 12 includes a first bottom heater 121 and a first side heater 122, the first bottom heater 121 is located below the first crucible 13 and heats the bottom of the first crucible 13, and the first side heater 122 is located on the side of the first crucible 13 and heats the side of the first crucible 13. Heating the first crucible 13 by the first bottom heater 121 and the first side heater 122 may ensure that the solid silicon material within the first crucible 13 is completely melted. Preferably, the melting furnace 1 may melt the silicon material by means of a graphite heater, a carbon-carbon heater or microwave heating.

In an optional implementation scheme, please continue to refer to FIG. 1, where it is shown that the pulling furnace 2 is provided therein with a second heater 21 and a second crucible 22, the second crucible is used for accommodating the molten silicon 4 from the interior of the melting furnace 1, and the second heater 21 is used for heating the second crucible 22. The material conveying portion introduces the molten silicon 4 within the first crucible 13 into the second crucible 22, and grows the molten silicon 4 within the second crucible 22 into the monocrystalline silicon 5 by drawing by pulling a seed crystal with a pulling mechanism within the pulling furnace 2.

In an optional implementation scheme, please continue to refer to FIG. 1, where it is shown that the first crucible 13 and the second crucible 22 are both provided thereabove with a heat-insulation cover 14, the heat-insulation cover 14 is used for wrapping the first crucible 13 and the first heater 12 within the melting furnace 1, the heat-insulation cover 14 has a good heat-insulation effect, and heat is not easily lost, which can save the electricity; the upper end of the heat-insulation cover 14 is open and is located on the same vertical line as a top feeding port 15 of the melting furnace 1, and the solid silicon material may be added into the first crucible 13 through the feeding port 15.

The thickness of the part of the heat-insulation cover 14 that is located above the second crucible 22 within the pulling furnace 2 is relatively thin, which has a certain heat-dissipation effect, facilitates increase of a pulling speed, and has a high production efficiency.

In this embodiment, it should also be noted that the material conveying portion includes a connecting pipe 3, one end of the connecting pipe 3 extends into the first crucible 13 within the melting furnace 1, and the other end of the connecting pipe 3 extends into the second crucible 22 within the pulling furnace 2. In this embodiment, a pressure difference between the melting furnace 1 and the pulling furnace 2 is utilized to achieve the introduction of the molten silicon 4 within the melting furnace 1 into the pulling furnace 2 through the connecting pipe 3, and under an effect that the pressure within the melting furnace 1 is greater than the pressure within the pulling furnace 2, the molten silicon 4 within the first crucible 13 flows into the pulling furnace 2 through the connecting pipe 3.

In a preferred example, the pressure of the melting furnace 1 is controlled by adjusting the argon gas inflow rate and the argon gas discharge rate within the melting furnace 1, an argon gas inlet 16 is provided on the upper side wall of the melting furnace 1, the argon gas may be introduced into the melting furnace 1 through the argon gas inlet 16, an argon gas outlet 17 is provided on the lower side wall of the melting furnace 1, and the argon gas within the melting furnace 1 may be discharged through the argon gas outlet 17, so the pressure of the melting furnace 1 is controlled by adjusting the argon gas inflow rate of the argon gas inlet 16 and the argon gas discharge rate of the argon gas outlet 17, so that the pressure within the melting furnace 1 is greater than the pressure within the pulling furnace 2. When it is required to introduce the molten silicon 4 from the melting furnace 1 into the pulling furnace 2, one end of the connecting pipe 3 is made to extend below the liquid level of the molten silicon 4 within the first crucible 13, and since the pressure within the melting furnace 1 is higher than the pressure within the pulling furnace 2, the molten silicon 4 will be introduced into the second crucible 22 within the pulling furnace 2 through the connecting pipe 3.

In an optional implementation scheme, the connecting pipe 3 includes a vertical portion 31 and an inclined portion 32 that communicate with each other, the vertical portion 31 is located within the melting furnace 1, the lower end of the vertical portion 31 extends into the first crucible 13, and the higher end of the inclined portion 32 is connected to the upper end of the vertical portion 31 and extends downwards from the interior of the melting furnace 1 to the second crucible 22 of the pulling furnace 2 in an inclined manner. When it is required to introduce the molten silicon 4 within the melting furnace 1 into the pulling furnace 2, the lower end of the vertical portion 31 is made to extend below the liquid level of the molten silicon 4 within the first crucible 13, and the pressure difference is utilized to make the molten silicon 4 within the first crucible 13 flow into the second crucible 22 through the vertical portion 31 and the inclined portion 32.

Preferably, the inclined portion 32 includes a first inclined portion 321 and a second inclined portion 322, the second inclined portion 322 is connected on the pulling furnace 2, and each of the pulling furnaces 2 has one independent second inclined portion 322, the lower end of the second inclined portion 322 extends into the second crucible 22 within the pulling furnace 2, and the higher end of the second inclined portion 322 is located outside the pulling furnace 2 and is connected to the first inclined portion 321. The first inclined portion 321 is connected to the melting furnace 1, the higher end of the first inclined portion 321 extends into the melting furnace 1 and is connected to the upper end of the vertical portion 31, and the lower end of the first inclined portion 321 is connected to the higher end of the second inclined portion 322. Thus, the melting furnace 1 is selectively connected to the second inclined portion 322 connected on any of the pulling furnaces 2 by the first inclined portion 321 when it rotates. Optionally, the contact surfaces of the first inclined portion 321 and the second inclined portion 322 that are connected to each other are connected by a flange, which facilitates the disassembly and assembly of the first inclined portion 321 and the second inclined portion 322, and using sealing rings on the flange contact surfaces can ensure sealing of the contact surfaces of the two portions.

Since part of the first inclined portion 321 is located outside the melting furnace 1 and part of the second inclined portion 322 is located outside the pulling furnace 2, in order to keep the temperature of the molten silicon 4 conveyed through the inclined portion 32, the part of the inclined portion 32 that is located outside the melting furnace 1 and the pulling furnace 2 is wrapped with a connecting pipe heat-insulation cover 6, and the connecting pipe heat-insulation cover 6 is further provided therein with a heating device, which may heat the first inclined portion 321 and the second inclined portion 322 by means of resistance heating or electric heating wires or the like, so as to ensure that the temperature within the first inclined portion 321 and the second inclined portion 322 is greater than 1430°C.

In this embodiment, it should also be noted that a switch valve 7 is further installed at a position where the first inclined portion 321 and the second inclined portion 322 are connected by the flange, and the switch valve 7 is used for controlling the interiors of the first inclined portion 321 and the second inclined portion 322 to communicate with or be closed to each other. The first inclined portion 321 may be selectively connected to the second inclined portion 322 on any of the pulling furnaces 2 when the melting furnace 1 rotates, in this case, the switch valve 7 is opened when it is required to introduce the molten silicon 4 into the second crucible 22 within the pulling furnace 2, the pulling furnace 2 and the melting furnace 1 communicate with each other by the first inclined portion 321 and the second inclined portion 322, and in this case, the molten silicon 4 within the first crucible 13 within the melting furnace 1 may be introduced into the second crucible 22 within the pulling furnace 2 through the first inclined portion 321 and the second inclined portion 322. After the completion of the feeding of the molten silicon 4 into the pulling furnace 2, the switch valve 7 is closed, the interiors of the first inclined portion 321 and the second inclined portion 322 are closed to each other, that is, the pulling furnace 2 and the melting furnace 1 become two independent chambers, and in this case, the melting furnace 1 may rotate to be selectively used in conjunction with the other pulling furnaces 2.

**In** this embodiment, it should also be noted that please continue to refer to FIG. 1, where it is shown that liftable crucible support legs 18 are provided within the melting furnace 1 and at the bottom of the first crucible 13, and the crucible support legs 18 are used for supporting the first crucible 13; when it is required to convey the molten silicon 4 into the pulling furnace 2, the crucible support legs 18 drive the first crucible 13 to rise until the lower end of the vertical portion 31 extends below the liquid level of the molten silicon 4 within the first crucible 13, and in this case, a pressure difference may be utilized to achieve the introduction of the molten silicon 4. After the completion of the conveyance of the molten silicon 4 to the pulling furnace 2, the crucible support legs 18 drive the first crucible 13 to descend until the lower end of the vertical portion 31 is separated from the liquid level of the molten silicon 4 within the first crucible 13, and in this case, due to the effect of gravity, the remaining molten silicon 4 within the vertical portion 31 will fall into the first crucible 13 through the lower end, and the remaining molten silicon 4 within the first inclined portion 321 and the second inclined portion 322 falls into the second crucible 22 through the lower end using the inclined surface, so that it may be ensured that a comparatively small amount of molten silicon 4 remains within the connecting pipe 3.

### Embodiment II

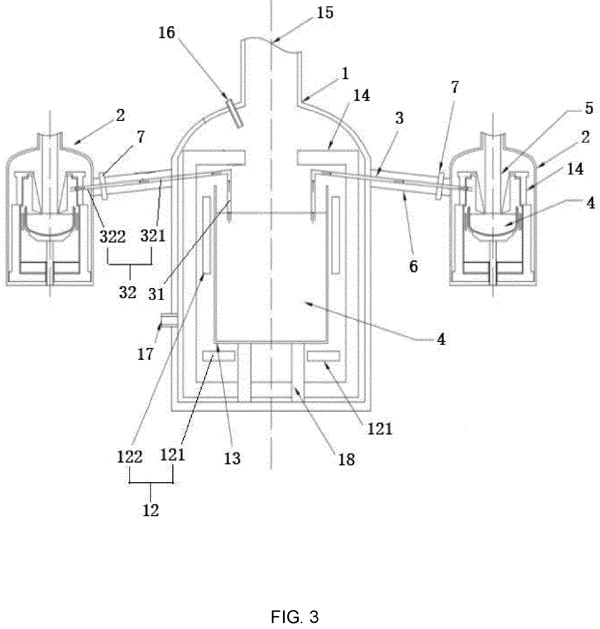

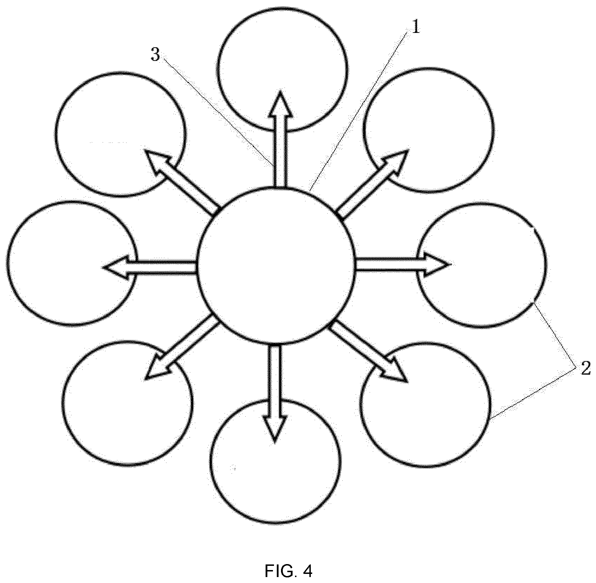

As shown in FIG. 3 and FIG. 4, the difference between the monocrystalline silicon drawing device in Embodiment II and the drawing device in Embodiment I is that in this embodiment, the material conveying portion is provided between the melting furnace 1 and each of the pulling furnaces 2, and the melting furnace 1 is made to communicate with one or more of the plurality of pulling furnaces 2 by selectively making one or more of the plurality of material conveying portions be in a communicating or closed state. Thus, the melting furnace 1 communicates with each of the pulling furnaces 2 by the material conveying portion, and each of the pulling furnaces 2 has an independent material conveying portion for conveying the molten silicon 4 without affecting each other.

The crucible support legs 18 may be used in conjunction with the switch valve 7. For example, when it is required to convey a material to the pulling furnace, the switch valve 7 is opened, the crucible support legs 18 lift the first crucible 13 so that the bottom of the vertical portion 31 extends below the liquid level of the molten silicon 4 within the first crucible 13, and the molten silicon 4 enters the pulling furnace 2 through the connecting pipe 3 under the effect of the pressure of the melting furnace 1; after the completion of the conveyance of the material, the crucible support legs 18 first lower the first crucible 13 so that the liquid level of the molten silicon 4 within the first crucible 13 is separated from the bottom of the vertical portion 31, then the remaining silicon material within the connecting pipe 3 flows into the pulling furnace 2 under the effect of gravity, and then after the remaining silicon material completely flows into the pulling furnace 2, the switch valve 7 is closed.

### Embodiment III

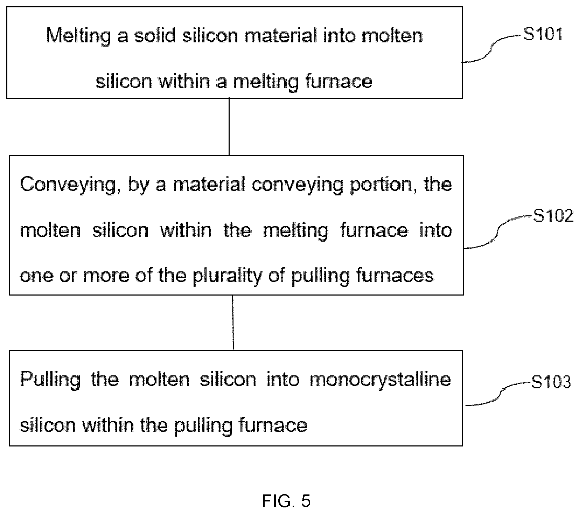

As shown in FIG. 1, FIG. 3 and FIG. 5, the embodiment of the disclosure further provides a monocrystalline silicon drawing method, which performs drawing using the aforesaid monocrystalline silicon drawing device, the drawing method comprising the steps of:
S101: melting a solid silicon material into molten silicon within a melting furnace;
   In this embodiment, it should be noted that the solid silicon material is added into the first crucible 13 within the melting furnace 1 through the feeding port 15, and the solid silicon material within the first crucible 13 is heated and melted by the first bottom heater 121 and the first side heater 122, so that the solid silicon material within the first crucible 13 is melted into the molten silicon 4.
S102: conveying, by a material conveying portion, the molten silicon within the melting furnace into one or more of the plurality of pulling furnaces;

In this embodiment, it should be noted that the argon gas is introduced into the melting furnace 1 through the argon gas inlet 16, the excess argon gas within the melting furnace 1 is discharged through the argon gas outlet 17, and the pressure of the melting furnace 1 is controlled by adjusting the argon gas inflow rate and the argon gas discharge rate, so that the pressure within the melting furnace 1 is greater than the pressure within the pulling furnace 2.

A plurality of pulling furnaces 2 are uniformly distributed around the melting furnace 1, and when the monocrystalline drawing process is performed, one or more of the plurality of pulling furnaces 2 may be selected to perform monocrystalline drawing; after the selection of the pulling furnace 2 for performing the monocrystalline drawing process, the switch valve 7 on the conveying portion corresponding to the selected pulling furnace 2 is opened to make the melting furnace 1 communicate with the selected pulling furnace 2, in this case, the crucible support legs 18 drive the first crucible 13 to rise until the lower end of the vertical portion 31 is located below the liquid level of the molten silicon 4 within the first crucible 13, and in this case, the connecting pipe 3 can convey the molten silicon 4 within the first crucible 13 to the second crucible 22 within the pulling furnace 2 using the pressure difference between the melting furnace 1 and the pulling furnace 2. After the completion of the conveyance of the molten silicon, the crucible support legs 18 first lower the position of the first crucible 13 so that the lower end of the vertical portion 31 is separated from the liquid level of the molten silicon 4 within the first crucible 13, the remaining molten silicon within the connecting pipe 3 flows into the pulling furnace 2 under the effect of gravity, and after the remaining molten silicon completely flows into the pulling furnace 2, the switch valve 7 is closed.

S103: pulling the molten silicon into monocrystalline silicon within the pulling furnace.

In this embodiment, it should be noted that after a certain amount of molten silicon 4 is held in the second crucible 22 within the pulling furnace 2, the molten silicon 4 is pulled into the monocrystalline silicon 5 by the pulling mechanism within the pulling furnace 2.

When the melting furnace 1 is configured to be rotatable, after the completion of the drawing process of the selected pulling furnace 2, the selected pulling furnace 2 may enter a cleaning stage, and in this case, the melting furnace 1 is driven to rotate by the base rotating device 11, and the melting furnace 1 drives the material conveying portion to rotate until it communicates with one or more of the other pulling furnaces 2 in a preparation state when it rotates.

When the material conveying portion is provided between the melting furnace 1 and each of the pulling furnaces 2, after the completion of the drawing process of the selected pulling furnace 2, the selected pulling furnace 2 may enter the cleaning stage, and in this case, the melting furnace 1 is made to communicate with one or more of the other pulling furnaces 2 in the preparation state by selectively making the material conveying portion on the one or more of the other pulling furnaces 2 in the preparation state be in a communicating state.

Then, the aforesaid steps are repeated to achieve the uninterrupted drawing of the monocrystalline silicon 5.

It should be understood that the aforesaid specific implementation schemes of the disclosure are only used for illustrating or explaining the principle of the disclosure, and do not form limitations on the disclosure. Thus, any modification, equivalent replacement, improvement, and so on made without departing from the spirit and scope of the disclosure shall be included in the scope of protection of the disclosure. In addition, the appended claims of the disclosure are intended to cover all changes and modifications that fall within the scope and boundary of the appended claims, or the equivalent forms of such scope and boundary.

## Claims

1. A monocrystalline silicon drawing device, comprising:
a melting furnace (1), which melts a solid silicon material into molten silicon (4);
a plurality of pulling furnaces (2), which are uniformly distributed around the melting furnace (1), receive the molten silicon (4) from the interior of the melting furnace (1), and grow the molten silicon (4) into monocrystalline silicon (5) by pulling;
a material conveying portion, which is provided between the melting furnace (1) and one or more of the plurality of pulling furnaces (2) and conveys the molten silicon (4) within the melting furnace (1) into one or more of the plurality of pulling furnaces (2).

2. The monocrystalline silicon drawing device of claim 1, wherein the material conveying portion is provided between the melting furnace (1) and each of the pulling furnaces (2), and the melting furnace (1) is made to communicate with one or more of the plurality of pulling furnaces (2) by selectively making one or more of the plurality of material conveying portions be in a communicating or closed state.

3. The monocrystalline silicon drawing device of claim 1, wherein the melting furnace (1) is configured to be rotatable, and one or more of the material conveying portions are fixed on the melting furnace (1), and the melting furnace (1) drives the material conveying portion to rotate until it communicates with one or more of the plurality of pulling furnaces (2) when it rotates.

4. The monocrystalline silicon drawing device of claim 2 or 3, wherein,
the melting furnace (1) is provided therein with a first crucible (13) for accommodating the solid silicon material and the molten silicon (4) and a first heater (12) for heating the first crucible (13);
the pulling furnace (2) is provided therein with a second crucible (22) for accommodating the molten silicon (4) and a second heater (21) for heating the second crucible (22), and
the first crucible (13) and the second crucible (22) are both provided thereabove with a heat-insulation cover (14).

5. The monocrystalline silicon drawing device of claim 4, wherein,
the material conveying portion includes a connecting pipe (3) and a switch valve (7) provided on the connecting pipe (3), one end of the connecting pipe (3) extends into the first crucible (13) within the melting furnace (1), the other end of the connecting pipe (3) extends into the second crucible (22) within the pulling furnace (2), and under an effect that the pressure within the melting furnace (1) is greater than the pressure within the pulling furnace (2), the molten silicon (4) within the first crucible (13) flows into the second crucible (22) within the pulling furnace (2) through the connecting pipe (3).

6. The monocrystalline silicon drawing device of claim 5, wherein the upper side wall of the melting furnace (1) is provided with an argon gas inlet (16) and the lower side wall thereof is provided with an argon gas outlet (17), and the pressure of the melting furnace (1) is controlled by adjusting the argon gas inflow rate of the argon gas inlet (16) and the argon gas discharge rate of the argon gas outlet (17), so that the pressure within the melting furnace (1) is greater than the pressure within the pulling furnace (2).

7. The monocrystalline silicon drawing device of claim 6, wherein the connecting pipe (3) includes a vertical portion (31) and an inclined portion (32) that communicate with each other, the vertical portion (31) is located within the melting furnace (1), and the lower end of the vertical portion (31) extends into the first crucible (13); the inclined portion (32) is connected to the upper end of the vertical portion (31) and extends downwards from the interior of the melting furnace (1) to the second crucible (22) of the pulling furnace (2) in an inclined manner.

8. The monocrystalline silicon drawing device of claim 7, wherein the inclined portion (32) includes a first inclined portion (321) and a second inclined portion (322), the first inclined portion (321) extends into the melting furnace (1), the second inclined portion (322) extends into the pulling furnace (2), the first inclined portion (321) and the second inclined portion (322) are connected by a flange, and the switch valve (7) is installed at the flange, and the first inclined portion (321) and the second inclined portion (322) communicate with or are closed to each other by the switch valve (7).

9. The monocrystalline silicon drawing device of claim 7, wherein the bottom of the first crucible (13) is provided with liftable crucible support legs (18),
wherein when the molten silicon (4) is conveyed to the pulling furnace (2), the crucible support legs (18) drive the first crucible (13) to rise so that the lower end of the vertical portion (31) contacts the liquid level of the molten silicon (4) within the first crucible (13);
after the completion of the conveyance of the molten silicon (4) to the pulling furnace (2), the crucible support legs (18) drive the first crucible (13) to descend so that the lower end of the vertical portion (31) is separated from the liquid level of the molten silicon (4) within the first crucible (13).

10. A monocrystalline silicon drawing method, which performs drawing using the monocrystalline silicon drawing device of any of claims 1-9, the drawing method comprising the steps of:
S101: melting a solid silicon material into molten silicon (4) within a melting furnace (1);
S102: conveying, by a material conveying portion, the molten silicon (4) within the melting furnace (1) into one or more of the plurality of pulling furnaces (2);
S103: pulling the molten silicon into monocrystalline silicon (5) within the pulling furnace (2).
